# EUROPEAN PATENT APPLICATION

(11) **EP 4 525 042 A1**
(43) Date of publication of application: **19.03.2025**
(21) Application number: 24193076.7
(22) Date of filing: 06.08.2024
(51) Int. Cl.: H01L 25/065, H02M 3/00, H01L 25/16, H01L 25/18

(54) **3D STACKED VOLTAGE REGULATOR WITH COMPONENTS DISTRIBUTED ON MULTIPLE WAFERS OR DICE**

(30) Priority: 18.09.2023 US 202318469201
(71) Applicant: INTEL Corporation, Santa Clara, CA 95054 (US)
(72) Inventor: KRISHNAMURTHY, Harish, Beaverton, 97006 (US); BUTZEN, Nicolas, Portland, 97229 (US)
(74) Representative: HGF

(57) **Abstract**

Embodiments herein relate to a voltage regular (VR) formed by components which are distributed over a stack of dice or wafers. Separate VRs can be provided in separate dice or wafers, where their outputs are coupled at an output path. A common control circuit can be used to control each VR. Passive components of a VR can be distributed on separate dice. For example, capacitors or inductors on the different dice or wafers can be coupled in parallel or in series, respectively. The stack can include dice or wafers of different types, such as silicon and Gallium Nitride. A first VR on a first type of die or wafer can be arranged in cascade with a second VR on a second type of die or wafer. The components in the different dice or wafers can be coupled by vias such as through-silicon vias.

## Description

### FIELD

The present application generally relates to the field of voltage regulators.

### BACKGROUND

Computing devices often rely on direct current (DC)-to-DC voltage converters, also referred to as voltage regulators when the output voltage is regulated, to obtain power. DC-to-DC voltage regulators, also referred to as power converters, are useful for converting a power supply at one DC voltage to another, typically lower DC voltage. For example, a voltage converter can convert the main supply voltage of a computing device, such as 12 V, down to lower voltages, such as 5 V, 3.3 V or 1.8 V. The lower voltages can be used by various components in the computing device, such as a Universal Serial Bus (USB) interface, memory such as dynamic random access memory (DRAM) and processing resources such as a central processing unit (CPU). However, it is challenging to supply power in an efficient and cost-effective manner.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1A depicts a cross-sectional view of a stack of dice 100 which each include a separate voltage regulator (VR) coupled to a common output path, in accordance with various embodiments.
FIG. 1B depicts a cross-sectional view of a stack of dice 150 in which a through-silicon via is formed separately in each die, in accordance with various embodiments.
FIG. 2 depicts a cross-sectional view of a stack of dice 200 which each include a separate VR coupled to a common output path, where a common control circuit (CC) in one die is to control the VR in each die, in accordance with various embodiments.
FIG. 3 depicts a cross-sectional view of a stack of dice 300 which each include a separate VR coupled to a common output path, where a compute die 310 includes a control circuit (CC) to control each VR and circuits 315 to be powered by the common output path, in accordance with various embodiments.
FIG. 4 depicts a cross-sectional view of a stack of dice 400 in which a die 410 includes a VR (VR(1)) with passive devices (passives(1)), and additional passive devices (passives(2) and passives(3)) 432 are distributed on dice 420 and 430, respectively, in accordance with various embodiments.
FIG. 5A depicts a cross-sectional view of a stack of dice 500 in which a die 510 includes a VR (VR(1)) with passive devices (passives(1)), additional passive devices (passives(2) and passives(3)) are distributed on dice 530 and 540, respectively, and a load die 520 is interposed between the dice 510 and 530, in accordance with various embodiments.
FIG. 5B depicts a cross-sectional view of a stack of dice 550 in which a die 580 includes a VR (VR(1)) with passive devices (passives(1)), additional passive devices (passives(2) and passives(3)) are distributed on dice 545 and 570, respectively, and a load die 560 is interposed between the dice 545 and 570, in accordance with various embodiments.
FIG. 6A depicts a cross-sectional view of a stack of dice 600 in which dice 610, 620 and 630 comprise a silicon substrate, die 640 comprises a Gallium Nitride (GaN) substrate, and VR(4) on the die 640 provides a power output to the VR 618 through a via 602, in accordance with various embodiments.
FIG. 6B depicts a cross-sectional view of a stack of dice 650 in which dice 660, 670 and 680 comprise a silicon substrate, dice 690 and 695 comprise a GaN substrate, and VR(4) and VR(5) on the dice 690 and 695, respectively, provide a power output to the VR 668 through a via 652, in accordance with various embodiments.
FIG. 7 depicts an example switched-capacitor VR 700 with one flying capacitor, Cf1, in accordance with various embodiments.
FIG. 8 depicts an example switched-capacitor VR 800 with multiple flying capacitors, Cf1, Cf2 and Cf3 in parallel, consistent with FIGs. 4, 5A and 5B, in accordance with various embodiments.
FIG. 9 depicts an example inductor-based VR 900 with one inductor, L1, in accordance with various embodiments.
FIG. 10 depicts an example inductor-based VR 1000 with multiple inductors, L1, L2 and L3 in series, consistent with FIGs. 4, 5A and 5B, in accordance with various embodiments.
FIG. 11 depicts an example switching transistor-based VR 1100, consistent with FIGs. 1A, 2, 6A and 6B, in accordance with various embodiments.
FIG. 12 illustrates an example of components that may be present in a computing system 1250 for implementing the techniques (e.g., operations, processes, methods, and methodologies) described herein.

### DETAILED DESCRIPTION

As mentioned at the outset, supplying power to computing products is becoming increasingly difficult. On the load side, domain voltages are decreasing while domain powers are increasing. Thus, domain currents are increasing dramatically. Simultaneously, because of the increasing domain currents, there is a demand to increase the input voltage of the package to keep the input current in check and improve end-to-end efficiency. Consequently, the demands on on-die or in-package voltage converters are hitting a breaking point. The voltage converters may be required to bridge a larger input-to-output voltage gap and provide more and more current, all while maintaining their conversion efficiency.

The capabilities of voltage converters, whether inductive like a buck converter or capacitive like a switched-capacitor converter, are heavily dependent on the available passive volume and their quality (e.g., time constant), and, to a lesser extent, the amount and quality of transistor conductance. Moreover, ideally the devices can handle the input voltage such that no devices have to be stacked or put in series (which would significantly lower efficiency and/or output current capability). Unfortunately, on-die passive volume is constrained by process technology, and both on-die transistors and capacitors tend to have lower voltage ratings, while in-package passives tend to have large time constants and cannot be freely scaled either without increasing total package size.

The solutions described herein address the above and other issues. In one aspect, the solutions introduce 3D stacking of multiple wafers and/or dice (e.g.., silicon wafers and/or dice) which include passive components such as capacitors and inductors, and/or active components such as power transistors, control and/or signal generation circuits, interface circuits and driver circuitry. All of these combined form one or multiple voltage converters or voltage regulators (VR) that are put in parallel to improve current capability and/or efficiency, or in multiple cascaded stages to allow for higher input voltages. The wafers/dies can be the same design with the same process technology, or different designs with different process technologies. By stacking multiple silicon wafers/dies on top of each other to form a larger voltage regulator 3D structure, there are many direct benefits.

First, the increased passive volume, spread over multiple dice, leads to an increased amount of passives per unit area, e.g. Farads per square mm. Similarly, multiple dice of power FET devices means the total amount of switch conductance per unit area available is increased as well. These can be directly leveraged to increase the VR's output current capability per unit area, improve the efficiency, and/or increase the input voltage (and thereby reduce the input current of the VR).

Second, because there is only need for one controller and set of other auxiliary circuitry per output domain, these circuits could be placed in a single wafer/die with the required number of metal layers, as well as support for analog devices such as analog transistors, thin-film resistors, etc., while the wafers/dies that contain the power FETs and/or passives only have the bare minimum of required metal layers. The end result is that the power circuitry is cheaper, and has less resistance in the current path, leading to overall lower cost per Amp of output current. Alternatively, there could be passive wafers/dies with only passive structures, further reducing costs while still positively impacting current capability and/or efficiency.

Third, using a scalable design where the number of dice in the 3D stack can be increased easily allows for improved scalability across different power domains and stock keeping unit (SKUs) of dies. For example, a low-end die with reduced power density and efficiency requirements could use fewer stacked wafers/dies compared to a high-power die, all with the same building blocks.

Fourth, stacking wafers/dies using different process technologies can allow for adding dedicated high-voltage capable devices with improved high-voltage figures of merit like Gallium Nitride (GaN) or Laterally-Diffused Metal-Oxide Semiconductor (LDMOS), or high-voltage capacitors, to further increase the input voltage at a better efficiency compared with a single-technology 2D approach.

Fifth, if multiple converter stages are implemented across the 3D stack, the proximity of those stages to each other leads to lower routing and interconnect losses compared with a conventional 2D approach, while simplifying the package design as well.

These and other features will be further apparent in view of the following discussion.

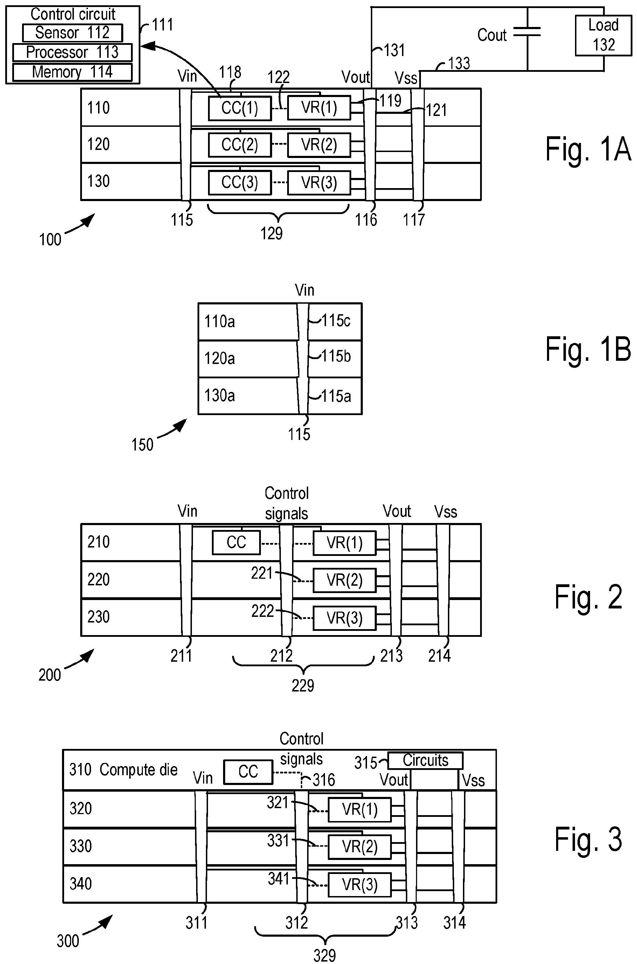

FIG. 1A depicts a cross-sectional view of a stack of dice 100 which each include a separate voltage regulator (VR) coupled to a common output path, in accordance with various embodiments. The examples provided herein refer to a singulated die of a wafer, but also apply where the die is replaced by an entire wafer. Thus, in one approach, a stack of wafers can be singulated into (stacked) dice to then be packaged. In another approach, a wafer-level product is not singulated but has a very large integrated circuit on an entire wafer. The term "dice/wafers" is used to refer to dice or wafers, and "die/wafer" is used to refer to a die or a wafer.

The dice are arranged on top of one another and may be separated by a thin passivation layer. The stack of dice includes dice 110, 120 and 130. Three dice are depicted in this example, but two or more dice may be provided in a stack. Each die includes a control circuit (CC) and an associated VR. For example, the die 110 includes CC(1) and VR(1), the die 120 includes CC(2) and VR(2), and the die 130 includes CC(3) and VR(3). CC(1) is represented by the example control circuit 111 which includes a sensor 112, a processor 113 and a memory 114. The memory stores instructions to be executed by the processor. The sensor is capable of sensing an output voltage of the VR and implementing a control loop to regulate the output voltage. The other CCs may be configured similarly to each regulate their own output voltage.

In some cases, the control circuit is considered to be separate from the VR.

VR(1)-VR(3) are constituent VRs of an overall VR 129.

The stack may include a number of through-silicon vias, including a via 115 which receives an input voltage Vin, a via 116 which receives an output voltage and current from each VR and a via 117 which is a common ground path of the VRs of the stack. When the die is made of silicon, the via is referred to as a through-silicon via (TSV). The vias may be etched after the stack is formed, in one approach. The via 115 is thus a common input voltage supply path for the CC and VR of each die, and the via 116 is a common output path for the current supplied by the VR of each die.

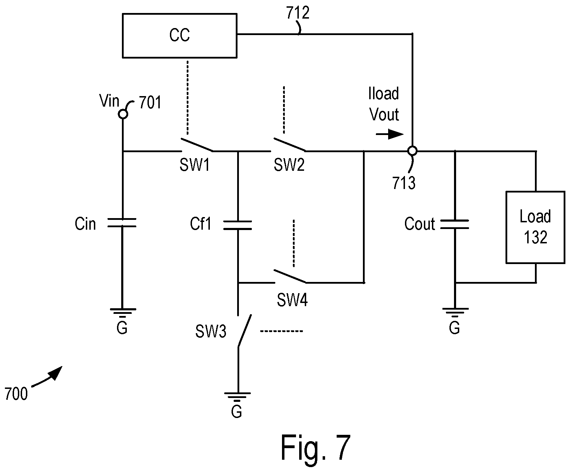

Each die can include metal dice above a substrate which provide conductive paths to between the vias and circuit components of the CC and VR. For example, a path 118 couples the via 115 carrying Vin to CC(1) and VR(1). A path 119 couples the current output of VR(1) to the via 116 carrying Vout. A path 121 couples VR(1) to the via 117 carrying a ground voltage Vss, e.g., 0 V. In one approach, each VR is regulated to an output at the same voltage, Vout. A dotted line 122 is signal path from CC(1) to VR(1) to control VR(1). For example, CC(1) may provide a signal for controlling switches and/or for driving power transistors in VR(1), depending on the type of VR used. See, e.g., FIG. 7-11 for example VR types. The dice 120 and 130 may be configured similarly as the die 110. The control circuit may send control signals to the VRs.

The vias 115, 116 and 117 can be considered to be common input, output and ground paths, respectively for the constituent VRs, VR(1)-VR(3), of the overall VR 100.

In one approach, the CCs are positioned one atop the other, and the VRs are positioned one atop the other. In other words, the CCs have a common footprint and the VRs have a common footprint.

A load 132 having an associated output capacitance Cout is coupled by a path 131 to the via 116 to receive Vout and by a path 133 to the via 117 to receive Vss. The load can be at a location outside the stack, for example, such as on one or more additional dice or other packages or components on the stack. The load can represent any of one or more components to be powered, such as a processor or memory chip.

In an example implementation, the VRs take up substantially the entire area of each die.

Generally, multiple wafers and/or dies can be stacked on atop the other to form a larger 3D VR structure. In the form shown in FIG. 1A, a VR design for a single die is adapted to allow for through-silicon via insertion, and the dice are stacked in such a way that input/output/ground terminal through-silicon vias line up to top-metal connects below such that a continuous connection can be formed between several dice. As such, the VR designs in each die will electrically be put in parallel, and their output current capability can be added to each other. Approximately, the total VRs current capability of the stack is obtained by is multiplying the current capability of one die by the number of dice. Another way of thinking about this, is that the stacking of several dice increases both the passive and transistor conduction density per unit area, which roughly proportionally increases current capability iso-efficiency.

Note that while the diagram in FIG 1A shows face-to-back connectivity, the same idea can be applied with face-to-face and back-to-back connections. Further, because VRs do not require high signal connectivity density, the stacking can be achieved using a wide range of approaches - from wafer-to-wafer, die-to-wafer or die-to-die solder bumps, microbumps or hybrid bonding. This allows one to choose whatever approach is most cost-effective.

In FIGs. 1A-6B, the vias 115, 211, 311, 551, 602, 652 are examples of a first through-silicon via which is to receive an input voltage. Vias 116, 213, 313, 514, 554, 604 and 654 are examples of a second through-silicon via which is to receive an output voltage. Vias 117, 214, 314, 515, 555, 605 and 655 are examples of a third through-silicon via which is to be coupled to a ground voltage. Vias 212, 312, 603 and 653 are examples of another through-silicon via or control path which is to carry control signals. Vias 412, 413, 512, 513, 552 and 553 are examples of another through-silicon via which is to carry voltages among passive devices.

FIG. 1B depicts a cross-sectional view of a stack of dice 150 in which a through-silicon via is formed separately in each die, in accordance with various embodiments. In FIG. 1A, the vias are etched after the stack is formed. In the approach of FIG. 1B, a via is etched in each die individually, and the vias are aligned to form a continuous via which extends the height of the stack. The via 115 is depicted as an example. The stack-high via 115 includes individual layer-high vias 115a, 115b and 115c in die 130a, 120a and 110a, respectively.

FIG. 2 depicts a cross-sectional view of a stack of dice 200 which each include a separate VR coupled to a common output path, where a common control circuit (CC) in one die is to control the VR in each die, in accordance with various embodiments. In this case, one central CC can control each VR in the stack. The stack of dice includes dice 210, 220 and 230. Vias 211, 213 and 214 carry Vin, Vout and Vss, respectively. An additional through-silicon via 212 allows the CC to send control signals to VR(2) and VR(3) using paths 221 and 222, respectively. These paths may be in metal dice above a substrate, for example. In one approach, a common control signal is provided to each VR. The common control signal can specify at least one of a duty cycle or a pulse frequency, for example. The common control signal can synchronize operation of each of the voltage regulators. The die 210 is an example of a base die while the dice 220 and 230 are examples of one or more additional dice.

Although one via is depicted for control signals, one or more may be provided. It is also possible to use interconnects other than, or in addition to, through-silicon vias for controls signals, Vin, Vout and Vss.

The vias 211, 213 and 214 can be considered to be common input, output and ground paths, respectively for the constituent VRs, VR(1)-VR(3), of the overall VR 229.

This approach can reduce the number of metal dice required in die 220 and 230 since they need not include a control circuit. Minimal device support is achieved. This reduces costs. Instead of duplicating the components of a single die in each layer of the full stack, there are two distinct layer designs. One design has all the necessary overhead circuitry like input/output (I/O), control, signal generation, and the metal stack and additional device support (e.g. thin-film resistors, thick-gate transistors, and so on) to support those structures, similar to each die in the FIG. 1A implementation. However, the other design dice only contains the passives and/or the power transistors (potentially with drivers) used in the voltage conversion circuit, and thus only require a minimal amount of device support in the front-end-of-line (FEOL) processing and a minimal metal layer count as well. FEOL is the first portion of integrated circuit (IC) fabrication where the individual components (transistors, capacitors, resistors, etc.) are patterned in the semiconductor. FEOL generally covers everything up to, but not including, the deposition of metal interconnect layers.

This design provides two advantages. First, the dice have higher current capability, because effectively those passive and/or active devices have lower series resistance due to the lower metal layer count, as well as lower cost. Combined, the cost per amp of current is better than that of a 2D structure. Second, the signal routing can first be distributed on the first design and then in the z-direction as shown in FIG. 2, or could first propagate in the z-direction (vertical direction) to then be distributed in the several dice.

FIG. 3 depicts a cross-sectional view of a stack of dice 300 which each include a separate VR coupled to a common output path, where a compute die 310 includes a control circuit (CC) to control each VR and circuits 315 to be powered by the common output path, in accordance with various embodiments.

In this case, a compute die 310 includes the CC which controls the VR-containing dice 320, 330 and 340. Vias 311, 313 and 314 carry Vin, Vout and Vss, respectively. An additional via 312 allows the CC to also provide control signals to VR(1), VR(2) and VR(3) using paths 321, 331 and 341, respectively, within the dice 320, 330 and 340, respectively. An additional path 316 for control signals extends in the compute die. The compute die includes circuits 315 which are coupled to a top of the via 313 to receive Vout. The circuits 315 may also be coupled to a top of the via 314 to receive Vss.

VR(1)-VR(3) are constituent VRs of an overall VR 329.

The vias 311, 313 and 314 can be considered to be common input, output and ground paths, respectively for the constituent VRs, VR(1)-VR(3), of the overall VR 300.

In this case, the CC is in a compute die that the VRs of the stack are supplying power to, rather than being on the same die as a VR. The control circuit (CC) along with other components such as I/O components and/or signal generation elements are integrated on the compute layer, which then feeds the necessary control signals to the various VR dice. An advantage is that the control, I/O and signal generation circuitry tend to be very small and could benefit from the scaling that an advanced process technology provides, such that the overhead on the compute die is minimal. Additionally, each VR layer can follow the same design (since it avoids one VR layer with the CC and other VR dice without it) to provide further efficiencies.

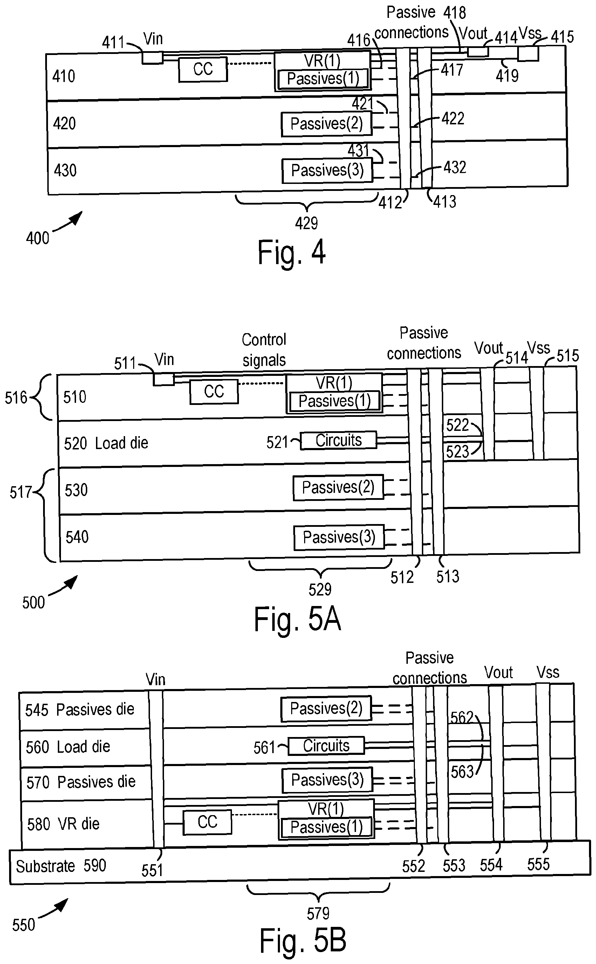

FIG. 4 depicts a cross-sectional view of a stack of dice 400 in which a die 410 includes a VR (VR(1)) with passive devices (passives(1)), and additional passive devices (passives(2) and passives(3)) 432 are distributed on dice 420 and 430, respectively, in accordance with various embodiments.

In this case, similar to FIG. 2, one die 410 includes the CC and a VR, VR(1). VR(1) includes passive devices or passives, passives(1), such as capacitors or inductors. Each die can include one or more passive devices. The remaining dice, dice 420 and 430, include passives, passives(2) and passives(3), respectively, which are coupled to passives(1), e.g., in parallel or in series. In one approach, these dice 420 and 430 are passive dice, e.g., dice which do not include active components such as transistors/switches which require power to operate. A contact 411 at the top of the stack may be used to receive Vin, e.g., from a power supply external to the stack. A stack-high via is not needed to carry Vin to the lower dice in this example. Vias 412 and 413 are used to electrically couple the passives in the different dice to one another. Dashed lines denote connections within a die to the vias 412 and 413, such as in metal layers of the dice. For example, the paths 416 and 417 denote connections of passives(1) to vias 412 and 413, respectively. The paths 421 and 422 denote connections of passives(2) to vias 412 and 413, respectively. The paths 431 and 432 denote connections of passives(3) to vias 412 and 413, respectively.

VR(1) with passives(1), along with passives(2) and passives(3), are constituent components of an overall VR 429.

In one approach, the passives are positioned one atop the other and have a common footprint.

The contacts 411, 414 and 415 can be considered to be input, output and ground paths, respectively for the overall VR 429.

The passives may be connected in parallel, such as for capacitors, or in series, such as for inductors. The output of VR(1) is thus multiplied by the auxiliary passives of the other die 420 and 430. The output of VR(1) is coupled to the contact 414 by a path 418 and to the contact 415 by a path 419.

The vias 412 and 413 may be through-silicon vias which extend the height of the stack as they connect passives in each die of the stack to one another. In contrast, the contacts 411, 414 and 415 may only connect to components within the die 410, in this example implementation.

In this implementation, the die 410 is provided according to a first design which includes the CC, and the dice 420 and 430 are provided according to a second design which does not include the CC or other active components. Instead, the second design only contains passive structures, making those dies/wafers passive and significantly reducing overall cost, while the first design can implement the power transistors or other active components of a VR. This approach should also provide linear current scaling with the number of dice, provided that the switch conductivity of the top layer is sufficient to support that current. If not, the top layer can be duplicated to increase total switch conductivity.

In FIGs. 1A-4, the VR dice are arranged consecutively in the stack, uninterrupted by other dice. Alternatively, the passive or VR wafers/dies could be on either side of a load domain wafer/die, such as depicted in FIGs. 5A and 5B.

FIG. 5A depicts a cross-sectional view of a stack of dice 500 in which a die 510 includes a VR (VR(1)) with passive devices (passives(1)), additional passive devices (passives(2) and passives(3)) are distributed on dice 530 and 540, respectively, and a load die 520 is interposed between the die 510 and 530, in accordance with various embodiments. In this example, the load die is interposed in the stack of dice used to provide the VR. That is, the load die is at an intermediate location in the stack between the top die and the bottom die. One or more dice used to provide the VR are above and below the load die. Note that the die which are above and below the load die include passive components in this example. However, other approaches are possible. For example, in FIG. 1A, 2 and 3, a load die can be interposed between die which contain active VR components.

A top layer of the stack, layer 510, includes the CC and a VR, VR(1) above the load die. VR(1) includes passives, passives(1), such as capacitors or inductors. Dice 530 and 540 below the load die include passives(2) and passives(3), respectively, which are coupled to passives(1). Die 520 is a load die which includes circuits 521 that receive power from the VR. The load die is between dice 510 and 530 in the stack, so that the VR dice are not continuously stacked on each other in the stack but are interrupted by one or more load dice. The circuits could include, e.g., a processor, a graphics processing unit or other execution units.

VR(1) with passives(1), along with passives(2) and passives(3), are constituent components of an overall VR 529.

The contact 511, via 514 and 515 can be considered to be input, output and ground paths, respectively for the overall VR 529.

Limiting the number of dice beneath the load die may provide advantages such as providing good signal bandwidth to the load die. Implementing multiple cascaded VR stages can allow for higher input voltages and/or lower output voltages. As an additional benefit, the proximity of the different stages means there will be minimal routing losses in between. In this case, first stage 516 includes the die 510 a second stage 517 includes the dice 530 and 540. Potentially multiple load dice can be provided in a stack where each load die is interposed between one or more VR dice.

A contact 511 at the top of the stack may be used to receive Vin. A stack-high via is not needed to carry Vin to the lower dice in this example. Vias 512 and 513 are used to electrically couple the passives in the different dice 510, 530 and 540 to one another in parallel or in series. Dashed lines denote connections within a die to the vias 512 and 513, such as in metal layers of the dice. Vias 514 and 515 for Vout and Vss need only extend in dice 510 and 520 since the passives are not powered. Paths 522 and 523 depict connections between the circuits 521 and the vias 514 and 515, respectively.

FIG. 5B depicts a cross-sectional view of a stack of dice 550 in which a die 580 includes a VR (VR(1)) with passive devices (passives(1)), additional passive devices (passives(2) and passives(3)) are distributed on dice 545 and 570, respectively, and a load die 560 is interposed between the dice 545 and 570, in accordance with various embodiments. In this case, the load die is above the VR die which contains the VR and CC rather than below it as in FIG. 5A. Also, the load die is separated from the VR layer by one or more other dice (die 570) instead of being adjacent to the VR layer as in FIG. 5A. A substrate 590 is depicted on which the stack is formed. The substrate can be a base layer of a package which contains the stack.

A bottom die 580 includes the CC and a VR, VR(1) below the load die. VR(1) includes passives(1) such as capacitors or inductors. Dice 545 and 560 include passives(2) and passives(3), respectively, which are coupled to passives(1). Die 545 is above the load die and die 570 is below the load die. The load die 560 includes circuits 561 that receive power from the VR.

VR(1) with passives(1), along with passives(2) and passives(3), are constituent components of an overall VR 579.

A stack-high via 551 may be used to receive Vin. The stack-high via extends down to the VR die 580 to provide power for the CC and VR(1). Vias 552 and 553 are used to electrically couple the passives in the different dice 545, 560 and 580 to one another. Dashed lines denote connections within a die to the vias 552 and 553, such as in metal layers of the dice. Vias 554 and 555 for Vout and Vss, respectively, extend in each die to allow connections to the CC and VR(1) in the bottom die 580. Paths 562 and 563 depict connections between the circuits 561 and the vias 554 and 555, respectively.

The vias 551, 554 and 555 can be considered to be input, output and ground paths, respectively for the overall VR 579.

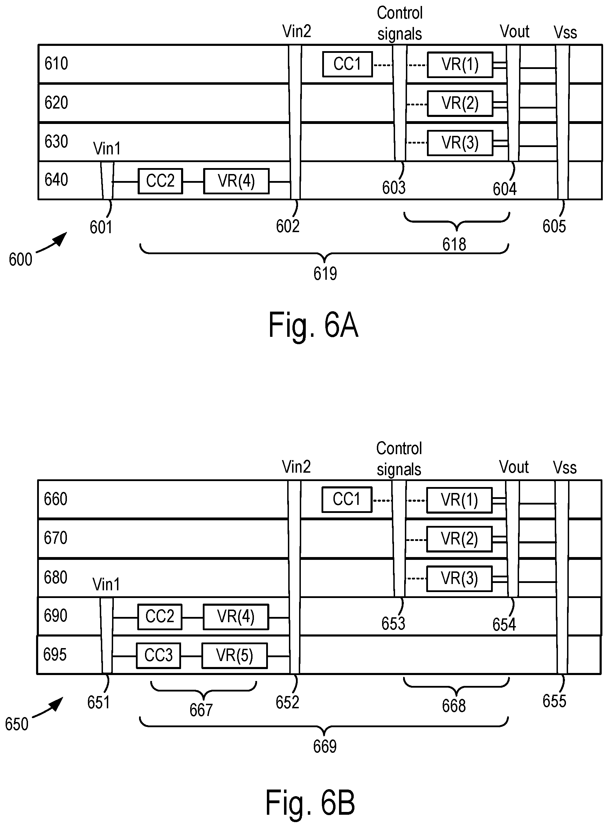

FIG. 6A depicts a cross-sectional view of a stack of dice 600 in which dice 610, 620 and 630 comprise a silicon substrate, die 640 comprises a Gallium Nitride (GaN) substrate, and VR(4) on the die 640 provides a power output to the VR 618 through a via 602, in accordance with various embodiments.

In this case, different dice are formed from different materials, e.g., silicon and GaN. A VR (VR(4)) formed in a GaN substrate, for instance, can handle higher voltages than a VR formed in a silicon substrate. In this example, a via 601 formed in the die 640 provides a voltage Vin1 to a control circuit CC2 of a VR, VR(4) in the die 640. Vin is a relatively high voltage such as 12 V. VR(4) converts the voltage to a lower level, Vin2. Vin2 is coupled to a via 602 which extends through the stack to reach the other dice 610, 620 and 620 to provide power to these dice as needed. In this example, a VR, e.g., VR(1), VR(2) and VR(3) is provide on dice 610, 620 and 630, respectively, which receive Vin2. In other examples, as discussed, one or more of the dice include the active and passive components of a VR and one or more other dice include passive but not active components of the VR. A control circuit CC1 provides control signals to VR(1), VR(2) and VR(3). The control signals can be provided to VR(1) on a metal layer and one or more vias within the die 610 and to VR(2) and VR(3) through a via 603.

The vias 601 and 602 can be considered to be input and output paths, respectively for a first VR, VR(4). The vias 602, 604 and 605 can be considered to be input, output and ground paths, respectively for the constituent VRs, VR(1)-VR(3), of a second VR 618. The first and second VRs are arranged in cascade and form an overall VR 619.

The outputs of VR(1), VR(2) and VR(3) are coupled to the output via 604, and VR(1), VR(2) and VR(3) are grounded by a ground via 605. The ground via may extend through dice 610, 620 and 630. In another approach, the ground via further extends in the die 640 to provide a ground path for VR(4). Vout could be 1 V, for example, so that Vout<Vin2<Vin1. The via 601 is shown as extending within die 640 only, where a connection can be made to a power supply. Optionally, the via 601 can extend to the top of the stack to make a connection to the power supply.

Various advantages can be obtained when the different dice are made using different process technologies and heterogeneous substrates. For example, high-voltage capable active devices, such as GaN or LDMOS, or passives, can be provided to facilitate higher input voltages while maintaining efficiency and cost. Moreover, because these process technologies typically do not have high transistor density, they could in turn benefit from the lower voltage process to take care of control, I/O, signal generation, calibration and so on.

In an example implementation, the stack comprises one or more additional dice in the stacked configuration, wherein: the one or more additional dice comprise a voltage regulator having an input path and output path; and the output path of the one or more additional dice is coupled to the input path of the plurality of dice.

FIG. 6B depicts a cross-sectional view of a stack of dice 650 in which dice 660, 670 and 680 comprise a silicon substrate, dice 690 and 695 comprise a GaN substrate, and VR(4) and VR(5) on the dice 690 and 695, respectively, provide a power output to the VR 668 through a via 652, in accordance with various embodiments. In this case, the dice 660, 670 and 680 are formed from a first substrate material, e.g., silicon, and the dice 690 and 695 are formed from a second substrate material, e.g., GaN. The concept could be extended to dice formed from a third or additional substrate material as well. Providing multiple GaN dice can result in greater efficiencies. In this case, a first VR 667 is formed by coupling the outputs of VR(4) and VR(5). In another example, one die such as 690 could contain active and passive components of a VR while another die contains passive but not active components of the VR. In another example, both dice 690 and 695 contain active and passive components of the VR but are controlled by a common control circuit. Other options are possible as well.

The vias 651 and 652 can be considered to be input and output paths, respectively for the first VR. The vias 652, 654 and 655 can be considered to be input, output and ground paths, respectively for the constituent VRs, VR(1)-VR(3), of a second VR 668. The first and second VRs are arranged in cascade and form an overall VR 669.

A via 653 is used to send control signals from CC1 to VR(1)-VR(3).

In this example, a via 651 formed in the dice 690 and 695 provides a voltage Vin1 to control circuits CC2 and CC3 of VR(4) and VR(5) in the dice 690 and 695, respectively. VR(4) and VR(5) convert Vin1 to a lower level, Vin2. Vin2 is coupled to a via 652 which extends through the stack to reach the other dice 660, 670 and 680 to provide power to these dice as needed. In this example, each die includes a VR, e.g., VR(1), VR(2) and VR(3) on dice 660, 670 and 680, respectively, which receives Vin2. In other examples, as discussed, one or more of the dice include the active components of a VR and one or more other dice include passive components. A control circuit CC1 provides control signals to VR(1), VR(2) and VR(3).

The outputs of VR(1), VR(2) and VR(3) are coupled to the output via 654, and VR(1), VR(2) and VR(3) are grounded by a ground via 655. The ground via may extend through dice 610, 620 and 630. Optionally, the ground via can further extend in the dice 690 and 695 to ground VR(4) and VR(5). The via 651 is shown as extending within dice 690 and 695, where a connection can be made to a power supply. Optionally, the via 651 can extend to the top of the stack to make a connection to the power supply.

With the solutions provided, the voltage conversion structure can be easily scaled according to the requirements of the different product SKUs. This means a single VR 3D design could support a wide range of products, simply by stacking more dice on top of each other. Finally, note that while the solutions can improve current capability, this can typically be traded-off in favor of higher efficiency and/or higher input voltages and/or lower output voltages.

The VRs depicted above can be of any type. Some examples include switched-capacitor-based VRs, inductor-based VRs and switching transistor-based VRs. The VRs can be DC-DC converters which convert one DC voltage to another DC voltage. Various examples are provided below.

FIG. 7 depicts an example switched-capacitor VR 700 with one flying capacitor, Cf1, in accordance with various embodiments. This example VR is configured as a single-stage charge pump with a single flying capacitor. A charge pump generally refers to a switching voltage converter that employs an intermediate capacitive storage element which is sometimes referred to as a flying capacitor or a charge transfer capacitor. One or more flying capacitors can be used. The charge pump is configured to provide Vout<Vin, in this example.

An input node 701 receives an input voltage Vin. For example, Vin may be a fixed power supply voltage sometimes referred to as Vdd in a semiconductor chip. Charge from the voltage is maintained in an input capacitor Cin which is connected to a ground node G.

A set of switches SW1-SW4 are controlled by a control circuit CC to transfer charge from the input node to Cf, and from Cf to an output node 713. The dotted lines depict control signal paths from the control circuit to the switches. Vout is a resulting voltage at the output node and Iload is a current drawn by the load 132. The output node is coupled to an output capacitor Cout, which is connected in series to a ground node G, and in parallel to the load. The switches may be MOSFETs, BJTs, or relay switches, for example. SW1 connects the top conductor of Cf to the input node 701 to receive a charge from Vin. SW2 then connects the top conductor of Cf to the output node 713 to transfer its charge to the output node. SW4 connects the bottom conductor of Cf to the output node 713 to transfer its charge to the output node. SW3 connects the bottom conductor of Cf to a ground node.

The CC provides the switches with appropriate control signals to provide Vout at a desired level. The control circuit can include a sensor (see also FIG. 1A) which monitors Vout at the output node via a feedback path 712. The CC can adjust the on/off times of the switches to regulate Vout at a target level.

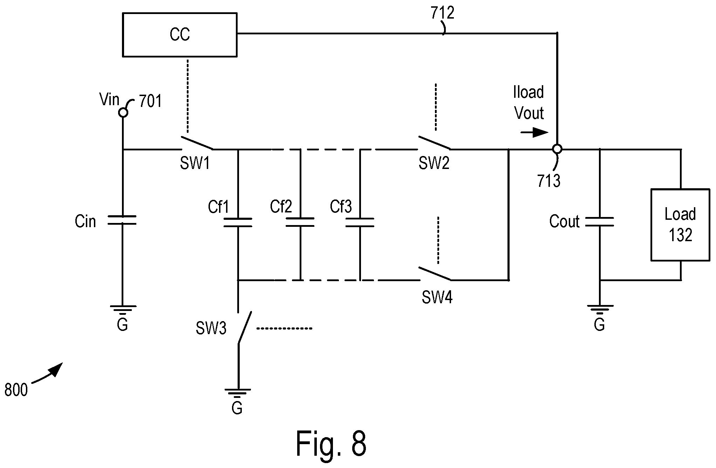

FIG. 8 depicts an example switched-capacitor VR 800 with multiple flying capacitors, Cf1, Cf2 and Cf3 in parallel, consistent with FIGs. 4, 5A and 5B, in accordance with various embodiments. The input node 701, output node 713, feedback path and CC of FIG. 7 are repeated. However, in this case, three flying capacitors are arranged in parallel. In one approach, each capacitor is in a separate die and the capacitors are coupled in parallel by connections made by vias in a stack. The connections are represented by the dashed lines. For example, consistent with FIG. 4, Cf1, Cf2 and Cf3 are in dice 410, 420 and 430, respectively, as represented by passives(1), passives(2) and passives(3), and the capacitors are coupled by the vias 412 and 413. In an example consistent with FIG. 5A, Cf1, Cf2 and Cf3 are in dice 510, 530 and 540, respectively, as represented by passives(1), passives(2) and passives(3), and the capacitors are coupled by the vias 512 and 513. In an example consistent with FIG. 5B, Cf1, Cf2 and Cf3 are in dice 580, 545 and 570, respectively, as represented by passives(1), passives(2) and passives(3), and the capacitors are coupled by the vias 552 and 553.

When capacitors are connected in parallel, the total capacitance is the sum of the individual capacitances. As a result, the total capacitance of the VR is increased so that its performance is increased. Moreover, when the capacitors are stacked one above the other, with a common footprint, the capacitance per area is increased.

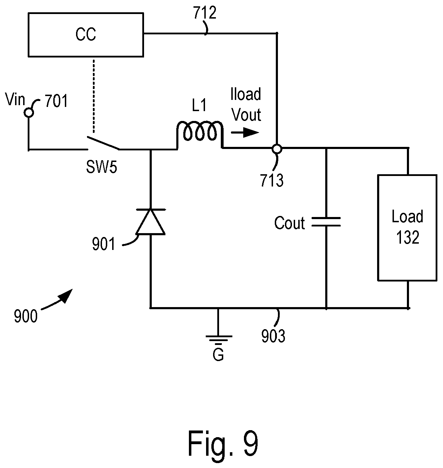

FIG. 9 depicts an example inductor-based VR 900 with one inductor, L1, in accordance with various embodiments. An inductor-based VR stores energy in, and releases energy from, an inductor instead of a capacitor. The inductor stores energy in a magnetic field. The CC controls the opening and closing of a switch SW5. When the switch is closed (conductive), an inductor L1 is coupled to the input node 701 and charged up. When the switch is open (non-conductive), the inductor discharges into the output node 713. A diode 901 prevents the inductor from discharging to the ground path 903.

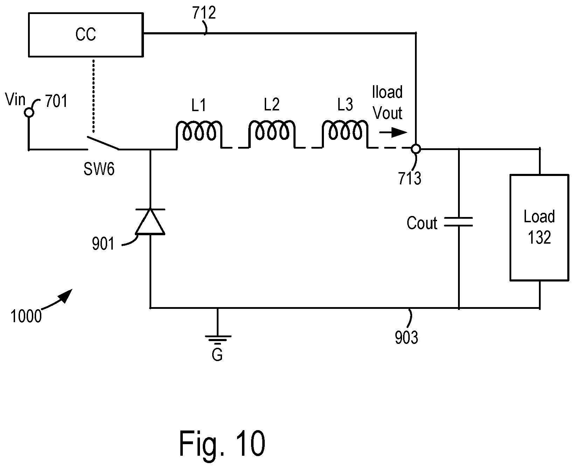

FIG. 10 depicts an example inductor-based VR 1000 with multiple inductors, L1, L2 and L3 in series, consistent with FIGs. 4, 5A and 5B, in accordance with various embodiments. The input node 701, output node 713, feedback path and CC of FIG. 9 are repeated. However, in this case, three inductors are arranged in parallel. In one approach, each inductor is in a separate die and the inductors are coupled in series by connections made by vias in a stack. The connections are represented by the dashed lines. For example, consistent with FIG. 4, L1, L2 and L3 are in dice 410, 420 and 430, respectively, as represented by passives(1), passives(2) and passives(3), and the inductors are coupled by the vias 412 and 413. In an example consistent with FIG. 5A, L1, L2 and L3 are in dice 510, 530 and 540, respectively, as represented by passives(1), passives(2) and passives(3), and the inductors are coupled by the vias 512 and 513. In an example consistent with FIG. 5B, L1, L2 and L3 are in dice 580, 545 and 570, respectively, as represented by passives(1), passives(2) and passives(3), and the inductors are coupled by the vias 552 and 553.

When inductors are connected in series, the total inductance is the sum of the individual inductances. As a result, the total inductance of the VR is increased so that its performance is increased. Moreover, when the inductors are stacked one above the other, the inductance per area is increased.

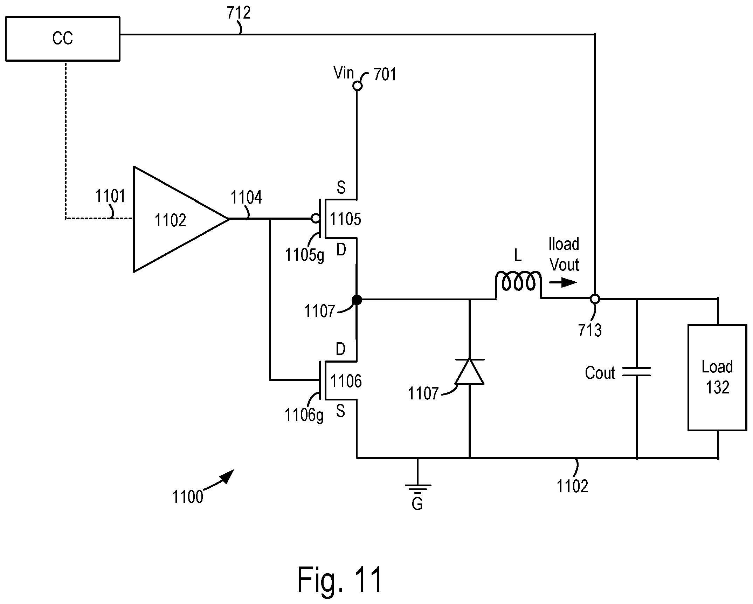

FIG. 11 depicts an example switching transistor-based VR 1100, consistent with FIGs. 1A, 2, 6A and 6B, in accordance with various embodiments. The VR includes p-type metal-oxide-semiconductor field-effect transistor (pMOSFET) 1105 in series with an n-type MOSFET 1106. The transistors 1105 and 1106 are also referred to as a high-side driver (or power switch or power FET) and a low-side driver, respectively. A driver 1102 provides an output on a path 1104 to control gates 1105g and 1106g of the transistors 1105 and 1106, respectively. The output may alternate between high and low levels. When the output is low, the transistor 1105 is conductive and allows charge from the input node 701 to reach a node 1107 which is between, and in series with, the transistors. The transistor 1106 is non-conductive so that the node is isolated from the ground path 1102. A diode 1107 also isolates the node 1107 from the ground path. The inductor L coupled to the node 1107 is then charged up.

When the output on the path 1104 is high, the transistor 1106 is conductive and grounds the node 1107. The transistor 1105 is non-conductive to isolate the node 1107 from the input node 701. The inductor L discharges to the output node 713.

The control signal provides a control signal to the driver 1102 on a path 1101 and can monitor Vout at the node 713 using a feedback path 712.

The VR is a buck converter in which the transistors are alternately turned on and off according to respective duty cycles and/or switching frequencies to maintain Vout at a desired level.

In one approach, a separate copy of the VR 1100 can be provided in each die in a stack and each VR is controlled by a respective CC. For example, consistent with FIG. 1A, the VR 1100 is provided in dice 110, 120 and 130 as represented by VR(1), VR(2) and VR(3), respectively, with control circuits CC(1), CC(2) and CC(3), respectively. The control circuits may operate independently, in one approach.

In an example consistent with FIG. 2, the VR 1100 is provided in dice 210, 220 and 230 as represented by VR(1), VR(2) and VR(3), respectively, with a common control circuit CC.

In an example consistent with FIG. 6A, the VR 1100 is provided in dice 610, 620 and 630 as represented by VR(1), VR(2) and VR(3), respectively, with a common control circuit CC1. The VR 1100 can also be provided in the die 640 as represented by VR(4) with a respective control circuit CC2.

In an example consistent with FIG. 6B, the VR 1100 is provided in dice 660, 670 and 680 as represented by VR(1), VR(2) and VR(3), respectively, with a common control circuit CC1. The VR 1100 can also be provided in the dice 690 and 695 as represented by VR(4) and VR(5), respectively, with a respective control circuit CC3. In another approach, VR(4) and VR(5) are controlled by a common control circuit.

Potentially, different types of VRs can be provided in a stack as constituent VRs of an overall VR. For example, a switched-capacitor-based VR could be in one die, an inductor-based VR can be in another die, and a switching transistor-based VR can be in another die. Various options are possible.

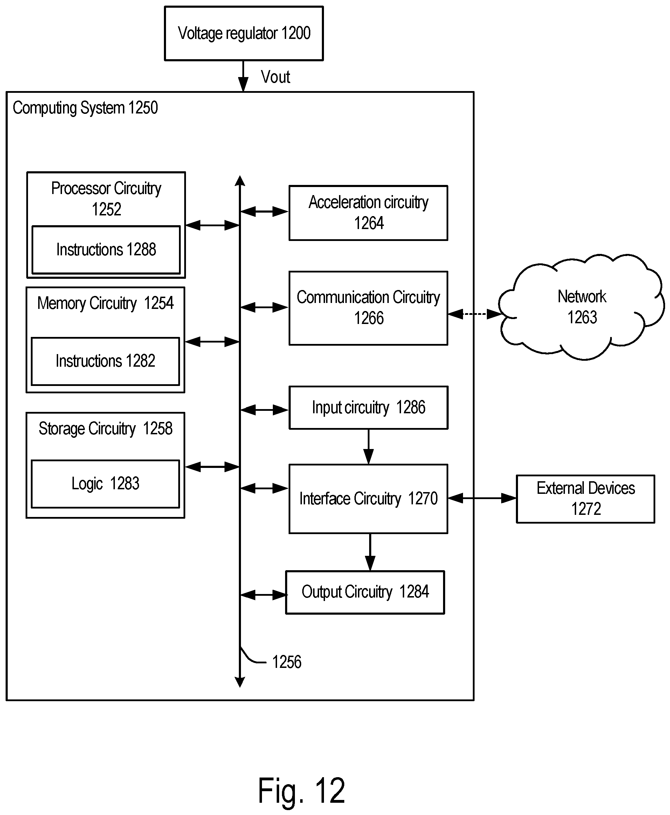

FIG. 12 illustrates an example of components that may be present in a computing system 1250 for implementing the techniques (e.g., operations, processes, methods, and methodologies) described herein. The voltage regulator 1200 may provide a voltage Vout to one or more of the components of the computing system 1250. The VR may be controlled by control signals provided by the processor circuitry 1252. The VR may include any of the VRs discussed herein including in FIG. 1A-11.

The memory circuitry 1254 may store instructions and the processor circuitry 1252 may execute the instructions to perform the functions described herein.

The computing system 1250 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1250, or as components otherwise incorporated within a chassis of a larger system. For one embodiment, at least one processor 1252 may be packaged together with computational logic 1282 and configured to practice aspects of various example embodiments described herein to form a System in Package (SiP) or a System on Chip (SoC).

The system 1250 includes processor circuitry in the form of one or more processors 1252. The processor circuitry 1252 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1252 may include one or more hardware accelerators (e.g., same or similar to acceleration circuitry 1264), which may be microprocessors, programmable processing devices (e.g., FPGA, ASIC, etc.), or the like. The one or more accelerators may include, for example, computer vision and/or deep learning accelerators. In some implementations, the processor circuitry 1252 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1252 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1252 may be coupled with or may include memory/storage and may be configured to execute instructions stored in the memory/storage to enable various applications or operating systems to run on the platform 1250. The processors (or cores) 1252 is configured to operate application software to provide a specific service to a user of the platform 1250. In some embodiments, the processor(s) 1252 may be a special-purpose processor(s)/controller(s) configured (or configurable) to operate according to the various embodiments herein.

As examples, the processor(s) 1252 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel@ Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1252 may be a part of a system on a chip (SoC), System-in-Package (SiP), a multi-chip package (MCP), and/or the like, in which the processor(s) 1252 and other components are formed into a single integrated circuit, or a single package, such as the Edison^{™} or Galileo^{™} SoC boards from Intel@ Corporation. Other examples of the processor(s) 1252 are mentioned elsewhere in the present disclosure.

The system 1250 may include or be coupled to acceleration circuitry 1264, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1264 may comprise logic blocks or logic fabric and other interconnected resources that may be programmed (configured) to perform various functions, such as the procedures, methods, functions, etc. of the various embodiments discussed herein. In such implementations, the acceleration circuitry 1264 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1252 and/or acceleration circuitry 1264 may include hardware elements specifically tailored for machine learning and/or artificial intelligence (Al) functionality. In these implementations, the processor circuitry 1252 and/or acceleration circuitry 1264 may be, or may include, an AI engine chip that can run many different kinds of AI instruction sets once loaded with the appropriate weightings and training code. Additionally or alternatively, the processor circuitry 1252 and/or acceleration circuitry 1264 may be, or may include, AI accelerator(s), which may be one or more of the aforementioned hardware accelerators designed for hardware acceleration of AI applications. As examples, these processor(s) or accelerators may be a cluster of artificial intelligence (Al) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1252 and/or acceleration circuitry 1264 and/or hardware accelerator circuitry may be implemented as Al accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 orA12 Bionic SoC, the Neural Processing Unit (NPU) within the HiSilicon Kirin 970 provided by Huawei^{®}, and/or the like. In some hardware-based implementations, individual subsystems of system 1250 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1250 also includes system memory 1254. Any number of memory devices may be used to provide for a given amount of system memory. As examples, the memory 1254 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1254 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1254 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1258 provides persistent storage of information such as data, applications, operating systems and so forth. In an example, the storage 1258 may be implemented via a solid-state disk drive (SSDD) and/or high-speed electrically erasable memory (commonly referred to as "flash memory"). Other devices that may be used for the storage 1258 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1254 and/or storage circuitry 1258 may also incorporate three-dimensional (3D) cross-point (XPOINT) memories from Intel@ and Micron^{®}.

The memory circuitry 1254 and/or storage circuitry 1258 is/are configured to store computational logic 1283 in the form of software, firmware, microcode, or hardware-level instructions to implement the techniques described herein. The computational logic 1283 may be employed to store working copies and/or permanent copies of programming instructions, or data to create the programming instructions, for the operation of various components of system 1250 (e.g., drivers, libraries, application programming interfaces (APIs), etc.), an operating system of system 1250, one or more applications, and/or for carrying out the embodiments discussed herein. The computational logic 1283 may be stored or loaded into memory circuitry 1254 as instructions 1282, or data to create the instructions 1282, which are then accessed for execution by the processor circuitry 1252 to carry out the functions described herein. The processor circuitry 1252 and/or the acceleration circuitry 1264 accesses the memory circuitry 1254 and/or the storage circuitry 1258 over the interconnect (IX) 1256. The instructions 1282 direct the processor circuitry 1252 to perform a specific sequence or flow of actions, for example, as described with respect to flowchart(s) and block diagram(s) of operations and functionality depicted previously. The various elements may be implemented by assembler instructions supported by processor circuitry 1252 or high-level languages that may be compiled into instructions 1288, or data to create the instructions 1288, to be executed by the processor circuitry 1252. The permanent copy of the programming instructions may be placed into persistent storage devices of storage circuitry 1258 in the factory or in the field through, for example, a distribution medium (not shown), through a communication interface (e.g., from a distribution server (not shown)), over-the-air (OTA), or any combination thereof.

The IX 1256 couples the processor 1252 to communication circuitry 1266 for communications with other devices, such as a remote server (not shown) and the like. The communication circuitry 1266 is a hardware element, or collection of hardware elements, used to communicate over one or more networks 1263 and/or with other devices. In one example, communication circuitry 1266 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1266 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1256 also couples the processor 1252 to interface circuitry 1270 that is used to connect system 1250 with one or more external devices 1272. The external devices 1272 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1250, which are referred to as input circuitry 1286 and output circuitry 1284. The input circuitry 1286 and output circuitry 1284 include one or more user interfaces designed to enable user interaction with the platform 1250 and/or peripheral component interfaces designed to enable peripheral component interaction with the platform 1250. Input circuitry 1286 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1284 may be included to show information or otherwise convey information, such as sensor readings, actuator position(s), or other like information. Data and/or graphics may be displayed on one or more user interface components of the output circuitry 1284. Output circuitry 1284 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1250. The output circuitry 1284 may also include speakers and/or other audio emitting devices, printer(s), and/or the like. Additionally or alternatively, sensor(s) may be used as the input circuitry 1284 (e.g., an image capture device, motion capture device, or the like) and one or more actuators may be used as the output device circuitry 1284 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1250 may communicate over the IX 1256. The IX 1256 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1256 may be a proprietary bus, for example, used in a SoC based system.

The number, capability, and/or capacity of the elements of system 1250 may vary, depending on whether computing system 1250 is used as a stationary computing device (e.g., a server computer in a data center, a workstation, a desktop computer, etc.) or a mobile computing device (e.g., a smartphone, tablet computing device, laptop computer, game console, loT device, etc.). In various implementations, the computing device system 1250 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a plurality of dice or wafers in a stacked configuration, wherein each die or wafer comprises a voltage regulator having an input path and output path; a first via which extends through the plurality of dice or wafers, wherein the first via is coupled to the input path of each voltage regulator; and a second via which extends through the plurality of dice or wafers, wherein the second via is coupled to the output path of each voltage regulator.

Example 2 includes the apparatus of Example 1, wherein the first and second vias comprise through-silicon vias.

Example 3 includes the apparatus of Example 1 or 2, further comprising: a control circuit; and a control path which extends through the plurality of dice or wafers, wherein the control path is to couple the control circuit to each of the voltage regulators to provide a common control signal to each of the voltage regulators.

Example 4 includes the apparatus of Example 3, wherein the common control signal is to specify at least one of a duty cycle or a pulse frequency.

Example 5 includes the apparatus of Example 3 or 4, wherein the control circuit is in a compute die or wafer in the stacked configuration, separate from the plurality of dice or wafers comprising the voltage regulators.

Example 6 includes the apparatus of any one of Examples 1-5, further comprising: a ground via which extends through the plurality of dice or wafers, wherein the ground via is coupled to each of the voltage regulators.

Example 7 includes the apparatus of any one of Examples 1-6, wherein each die or wafer of the plurality of dice or wafers comprises a control circuit to control the voltage regulator of the die or wafer.

Example 8 includes the apparatus of any one of Examples 1-7, further comprising one or more additional dice or wafers in the stacked configuration, wherein: the one or more additional dice or wafers comprise a voltage regulator having an input path and output path; and the output path of the one or more additional dice or wafers is coupled to the input path of the plurality of dice or wafers.

Example 9 includes the apparatus of Example 8, wherein: the one or more additional dice or wafers comprise a gallium nitride substrate; and the plurality of dice or wafers comprise a silicon substrate.

Example 10 includes the apparatus of any one of Examples 1-9, further comprising a load die or wafer coupled to the second via, wherein the load die or wafer is interposed in the plurality of dice or wafers and the first and second vias extend through the load die or wafer.

Example 11 includes the apparatus of any one of Examples 1-10, further comprising at least one of an integrated circuit, a System on Chip, a System in Package or a computing device in which the plurality of dice or wafers are provided.

Example 12 includes a voltage regulator, comprising: a plurality of dice or wafers in a stacked configuration, wherein the plurality of dice or wafers comprise a base die or wafer and one or more additional dice or wafers, the base die or wafer comprises a passive component and an active component of the voltage regulator and the one or more additional dice or wafers comprise a passive component of the voltage regulator; and one or more vias which extend through the plurality of dice or wafers, wherein the one or more vias are coupled to the passive component of each die or wafer.

Example 13 includes the voltage regulator of Example 12, wherein the passive component of each die or wafer comprises a flying capacitor, and the flying capacitors of each die or wafer are coupled in parallel to one another by the one or more vias. Example 14 includes the voltage regulator of Example 12 or 13, wherein the passive component of each die or wafer comprises an inductor, and the inductors are coupled in series with one another by the one or more vias.

Example 15 includes the voltage regulator of any one of Examples 12-14, wherein the base die or wafer comprises a power transistor of the voltage regulator and the one or more additional die or wafer do not include a power transistor of the voltage regulator.

Example 16 includes the voltage regulator of any one of Examples 12-15, wherein the passive components have a common footprint.

Example 17 includes an apparatus, comprising: a memory to store instructions; and a processor to execute the instructions to: monitor an output voltage of a voltage regulator which is distributed across a plurality of dice orwafers, wherein the plurality of dice or wafers are in a stacked configuration; and based on the monitored output voltage, send control signals to the plurality of dice or wafers to regulate the output voltage, wherein: the voltage regulator comprises components in each die or wafer which are coupled to a common input path and to a common output path; the common input path is to receive an input voltage; and the common output path is to provide the output voltage.

Example 18 includes the apparatus of Example 17, wherein the processor is to send the control signals in through-silicon vias which extend in the plurality of dice or wafers.

Example 19 includes the apparatus of Example 17 or 18, wherein: the components comprise switches; and the processor is to send the control signals to the switches to control a transfer of charge from the common input path to the common output path in each die or wafer of the plurality of dice or wafers.

Example 20 includes the apparatus of any one of Examples 17-19, wherein: the components comprise drivers for power transistors; and the processor is to send the control signals to the drivers to control a transfer of charge from the common input path to the common output path in each die or wafer of the plurality of dice or wafers.

Example 21 includes a method, comprising: providing an input voltage to a plurality of dice or wafers in a stacked configuration, wherein each die or wafer comprises a voltage regulator having an input path and output path, the input voltage is provided to a first via which extends through the plurality of dice or wafers, and the first via is coupled to the input path of each voltage regulator; and receiving an output voltage from the voltage regulators at a second via which extends through the plurality of dice or wafers, wherein the second via is coupled to the output path of each voltage regulator.

Example 22 includes the method of Example 21, further comprising providing a common control signal to each of the voltage regulators via a control path which extends through the plurality of dice or wafers.

Example 23 includes the method of Example 21 or 22, further comprising grounding each of the voltage regulators through a via which extends through the plurality of dice or wafers.

Example 24 includes the method of any one of Examples 21-23, further comprising converting a voltage to the input voltage at one or more additional dice or wafers in the stacked configuration, wherein the one or more additional dice or wafers comprise a gallium nitride substrate, and the plurality of dice or wafers comprise a silicon substrate.

Example 25 includes a non-transitory machine-readable storage including machine-readable instructions that, when executed, cause a processor or other circuit or computing device to implement the method of any one of Examples 21-24.

Example 26 includes a computer program comprising instructions which, when the program is executed by a computer, cause the computer to carry out the method of any one of Examples 21-24.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a plurality of dice or wafers in a stacked configuration, wherein the plurality of dice or wafers comprise a base die or wafer and one or more additional dice or wafers, the base die or wafer and the one or more additional dice or wafers comprise passive and active components of one or more voltage regulators; and
one or more vias which extend through the plurality of dice or wafers, wherein the one or more vias are coupled to the passive and active components of the plurality of dice or wafers.

2. The apparatus of claim 1, wherein the one or more voltage regulators comprise a single voltage regulator distributed across the plurality of dice or wafers.

3. The apparatus of claim 1, wherein the one or more voltage regulators comprise different voltage regulators in different die or wafers of the plurality of dice or wafers.

4. The apparatus of claim 3, wherein the one or more vias comprise:
a first via coupled to input paths of the different voltage regulators; and
a second via coupled to output paths of the different voltage regulators.

5. The apparatus of claim 4, further comprising a load die or wafer coupled to the second via, wherein the load die or wafer is interposed in the plurality of dice or wafers and the first and second vias extend through the load die or wafer.

6. The apparatus of any one of claim 3-5, further comprising:
a control circuit; and
a control path which extends through the plurality of dice or wafers, wherein the control path is to couple the control circuit to the different voltage regulators to provide a common control signal to the different voltage regulators.

7. The apparatus of claim 6, wherein the common control signal is to specify at least one of a duty cycle or a pulse frequency.

8. The apparatus of claim 6 or 7, wherein the control circuit is in a compute die or wafer in the stacked configuration, separate from the plurality of dice or wafers comprising the different voltage regulators.

9. The apparatus of any one of claims 3-8, wherein the plurality of dice or wafers comprise different control circuits to control the different voltage regulators.

10. The apparatus of any one of claims 1-9, wherein the passive components comprise flying capacitors coupled in parallel to one another by the one or more vias.

11. The apparatus of any one of claims 1-10, wherein the passive components comprise inductors coupled in series with one another by the one or more vias.

12. The apparatus of any one of claims 1-11, wherein the passive components have a common footprint.

13. A method, comprising:
providing an input voltage to a first via which extends through a plurality of dice or wafers in a stacked configuration, wherein the plurality of dice or wafers comprise a base die or wafer and one or more additional dice or wafers, the base die or wafer and the one or more additional dice or wafers comprise passive and active components of one or more voltage regulators, and the first via is coupled to an input path of the one or more voltage regulators; and
receiving an output voltage from the one or more voltage regulators at a second via which extends through the plurality of dice or wafers, wherein the second via is coupled to an output path of the one or more voltage regulators.

14. The method of claim 13, wherein the one or more voltage regulators comprise a single voltage regulator distributed across the plurality of dice or wafers.

15. The method of claim 13, wherein the one or more voltage regulators comprise different voltage regulators in different die or wafers of the plurality of dice or wafers.
